# FASCICULE DE BREVET EUROPEEN

(11) **EP 1 243 070 B1**
(45) Date de publication et mention de la délivrance du brevet: **03.09.2003**
(21) Numéro de dépôt: 00990083.8
(22) Date de dépôt: 20.12.2000
(51) Int. Cl.: H03C 3/28, H03C 7/02, H03B 5/18

(54) **OSCILLATEUR A RESONATEUR DIELECTRIQUE ET DISPOSITIF DE COMMANDE VOCALE**
OSZILLATOR MIT RESONANTEN DIELEKTRIKUM UND SPRACHGESTEUERTE EINRICHTUNG
DIELECTRIC RESONATOR OSCILLATOR AND VOICE CONTROL DEVICE

(30) Priorité: 31.12.1999 FR 9916866
(43) Date de publication de la demande: 25.09.2002
(73) Titulaire: Thomson Licensing S.A., 92100 Boulogne-Billancourt (FR)
(72) Inventeur: LE NAOUR, Jean-Yves, Thomson Multimedia, F-92648 Boulogne (FR); DENIS, Bernard, Thomson Multimedia, F-92648 Boulogne (FR); ROBERT, Jean-Luc, Thomson Multimedia, F-92648 Boulogne (FR)
(74) Mandataire: Ruellan-Lemonnier, Brigitte
(86) Numéro de dépôt international: FR0003615
(87) Numéro de publication internationale: WO01050591

(56) Documents cités:
- PATENT ABSTRACTS OF JAPAN vol. 007, no. 140 (E-182), 18 juin 1983 (1983-06-18) & JP 58 054706 A (FUJITSU KK), 31 mars 1983 (1983-03-31)

## Description

L'invention se rapporte au domaine des transmissions de signaux, notamment dans la gamme des super hautes fréquences ou SHF ("Super High Frequencies" en langue anglaise). L'invention concerne plus particulièrement un oscillateur à résonateur diélectrique pour la transposition de signaux audio dans la gamme de fréquences SHF. L'invention concerne également un dispositif de commande vocale.

Les oscillateurs SHF à résonateur diélectrique ("Dielectric Resonator Oscillator" ou DRO en langue anglaise) sont communément utilisés dans les dispositifs de transmission de signaux SHF, permettant d'obtenir des oscillateurs performants, de faible encombrement et de faible coût. Ils sont notamment utilisés comme oscillateur local de transposition de fréquence dans les convertisseurs à faible bruit pour la réception satellite.

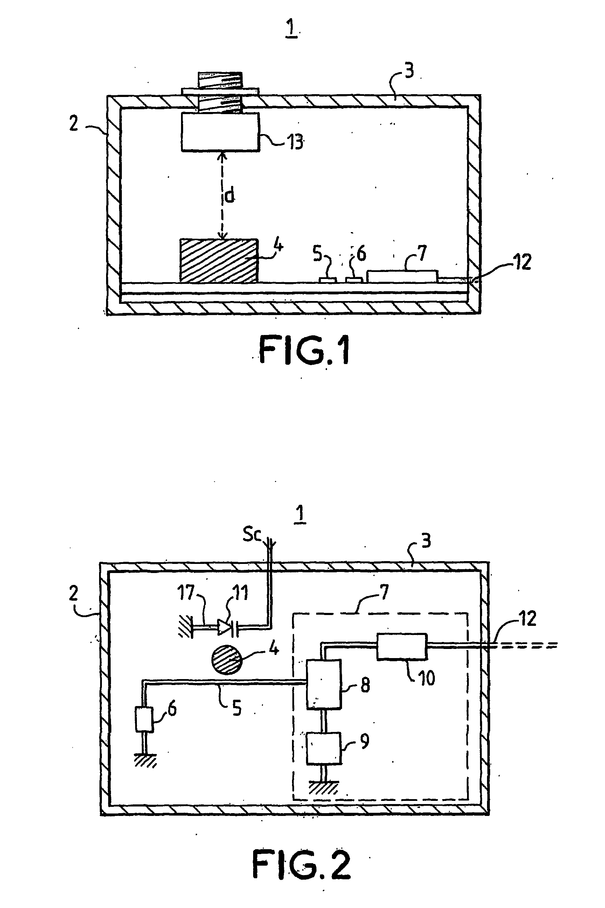

La figure 1 représente schématiquement un oscillateur à résonateur diélectrique 1 à vis réglable de l'art antérieur. Celui-ci comprend une cavité électromagnétique 2 délimitant par ses parois 3 un résonateur diélectrique 4 couplé à une première ligne microruban 5. Un circuit 7, illustré sur la figure 2 représentant un autre résonateur de l'art antérieur qui sera décrit ultérieurement pour le restant, est commun aux deux résonateurs et remplit les mêmes fonctions. En conséquence, la description des principaux composants de ce circuit 7 se fera en se reportant à la figure 2. De façon générale, pour simplifier la description, les mêmes références seront utilisées pour désigner les éléments remplissant des fonctions identiques dans la présente demande. La ligne de couplage 5 est d'une part reliée au circuit actif 7 et d'autre part à une charge 6 d'adaptation d'impédance. Le circuit actif 7 comprend un élément actif 8, du type d'un transistor bipolaire ou FET, un élément 9 déstabilisant de la partie active, par exemple du type d'un circuit LC, et un élément 10 d'adaptation d'impédance de sortie, du type de lignes microruban. Il est connu que le circuit RLC équivalent au résonateur est le siège d'oscillations amorties, l'amortissement de ces oscillations étant dû à la partie résistive du circuit RLC. Ce circuit actif à résistance négative a alors pour fonction d'apporter l'énergie nécessaire à l'entretien des oscillations, de sorte que le signal délivré à une sortie 12 de l'oscillateur soit un signal oscillant sans amortissements. Il est également connu de l'homme du métier que l'ensemble formé par le résonateur couplé par la ligne microruban au circuit actif doit présenter des conditions d'oscillation favorables à la fréquence d'oscillation recherchée. Dans l'oscillateur de la figure 1, une vis 13 pénètre la paroi 3 de la cavité en regard du résonateur diélectrique 4. Son degré de pénétration dans une direction perpendiculaire à la surface en regard du résonateur engendre une perturbation de la distribution des champs électromagnétiques dans la cavité et par suite une modification de la fréquence de résonance du circuit résonant équivalent. Ainsi, la variation de la distance d entre la partie terminale de la vis pénétrant dans la cavité et la surface supérieure du résonateur implique une modification de la fréquence du signal généré par l'oscillateur. Cependant, ce type d'oscillateur, faisant intervenir un réglage manuel de la distance d, ne permet pas de respecter fidèlement et sans distorsions les variations fines autour d'une fréquence centrale ; il n'est donc pas adapté pour la transmission de signaux audio.

Pour s'affranchir des problèmes liés aux réglages mécaniques comme cités ci-dessus, il est également connu des oscillateurs dits électroniques, tels que celui illustré sur la figure 2 représentant un oscillateur à résonateur diélectrique à varactor. Un varactor 11 relié à une seconde ligne 17 microruban couplée au résonateur diélectrique, reçoit un signal de commande Sc de tension variable significatif d'un signal audio à transmettre. L'ensemble résonateur-varactor se comporte comme un circuit résonant fixant la fréquence d'oscillation de l'oscillateur. Ainsi, la variation de la tension délivrée par le signal Sc modifie la fréquence d'oscillation du circuit oscillant 7. Cependant, la mise en oeuvre d'un varactor a pour effet une dégradation du bruit de phase de l'oscillateur et par suite une dégradation de la qualité du signal généré en sortie de l'oscillateur.

La demande de brevet japonais JP 58 054706 A décrit un oscillateur à résonateur diélectrique, modifié en ce qu'il comprend une membrane mobile dans un des murs de la cavité. La membrane est déplacée sous l'effet de la pression des ondes acoustiques, ce déplacement modifiant la distribution des champs éléctromagnétiques dans la cavité.

L'invention a pour objet de remédier aux problèmes de l'art antérieur en proposant un oscillateur à résonateur diélectrique pour la transposition de signaux audio.

A cet effet, l'invention a pour objet un oscillateur à résonateur diélectrique, comprenant un résonateur diélectrique confiné dans une cavité résonante pour la génération d'un signal oscillant à une fréquence centrale prédéterminée, les dimensions du résonateur et les conditions aux limites dans la cavité étant aptes à déterminer la fréquence de résonance du résonateur et des moyens sensibles aux ondes de pression acoustique aptes à modifier la distribution des champs électromagnétiques dans la cavité en fonction desdites ondes de pression acoustiques. Les moyens sensibles aux ondes acoustiques comprennent une membrane mobile sous l'effet des ondes acoustiques, ladite membrane engageant une bobine métallique dans la cavité.

Ainsi, les moyens sensibles aux ondes de pression acoustique évolue directement au rythme de la pression acoustique exercée à l'une des entrées desdits moyens sensibles. L'invention permet de cette sorte de générer un signal modulé directement par le signal audio à cette entrée.

Selon un mode de réalisation, lesdits moyens sensibles aux ondes de pression acoustique comprennent des moyens de transduction acoustique pour convertir des ondes de pression acoustique en déplacement d'au moins une partie de moyens amovibles en regard du résonateur, le déplacement d'au moins une partie de ces moyens amovibles sous l'effet d'ondes de pression acoustique étant capable de modifier la distribution des champs électromagnétiques dans la cavité.

Selon un mode de réalisation, le déplacement desdits moyens amovibles s'effectue sous forme de vibrations.

Selon un mode de réalisation, l'oscillateur comprend des moyens de réglage pour régler la fréquence centrale du résonateur.

Selon un mode de réalisation, lesdits moyens de réglage comprennent une vis de réglage pouvant s'engager dans la cavité pour modifier la distribution des champs électromagnétiques dans celle-ci.

Selon un mode de réalisation, l'oscillateur comprend des moyens de commutation pour commuter la modulation du signal généré par le résonateur par les ondes acoustiques vers une modulation par des données transmises sur une voie.

Selon un mode de réalisation, un dipôle actif est couplé audit résonateur par des moyens de couplage pour l'entretien des oscillations.

L'invention a également pour objet un dispositif de commande vocale, caractérisé en ce qu'il comprend un oscillateur selon l'invention.

D'autres caractéristiques et avantages de la présente invention ressortiront de la description des exemples de réalisation qui vont suivre, pris à titre d'exemples non limitatifs, en référence aux figures annexées dans lesquelles :
- les figures 1 et 2, déjà décrite, représentent deux oscillateurs à résonateur diélectrique de l'art antérieur,
- la figure 3 représente un oscillateur à résonateur diélectrique selon un mode de réalisation de l'invention,
- la figure 4 illustre une courbe représentant la variation de la fréquence que subit le signal en sortie de l'oscillateur de la figure 3 en fonction de la distance d,
- la figure 5 représente un dispositif de télécommande selon l'invention.

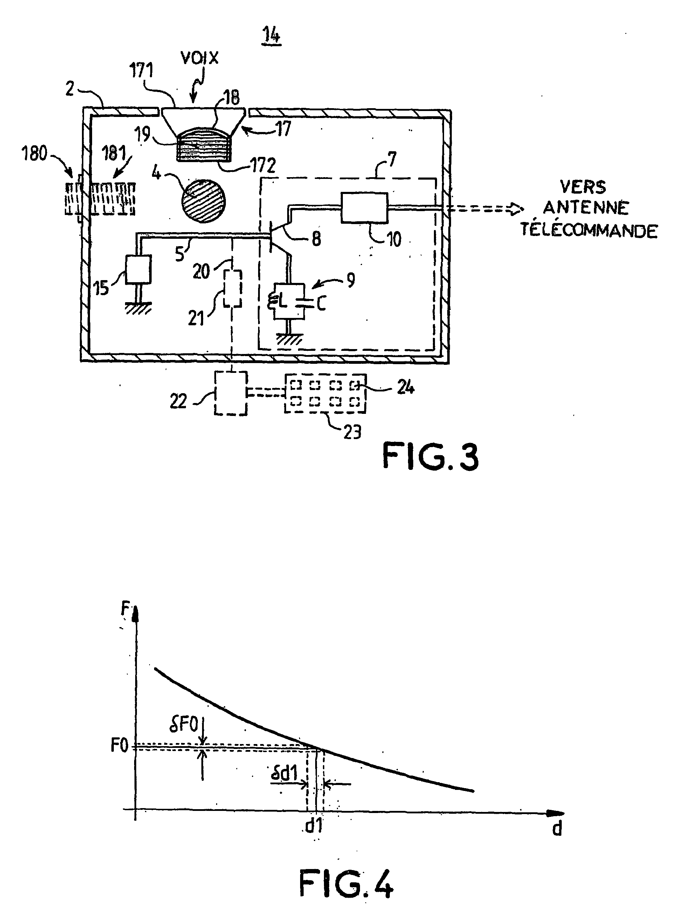

La figure 3 illustre un oscillateur 14 selon l'invention. II comprend une cavité résonante 2 à l'intérieur de laquelle se trouve un résonateur 4 couplé électromagnétiquement à une ligne microruban 5. La ligne 5 relie une charge 15 à un circuit actif 7. Le circuit actif comprend à son entrée reliée à la ligne 5 un transistor de type FET, dont la source est reliée à un circuit par exemple du type LC relié à la masse, dont le rôle est de rendre instable l'étage à transistor, et dont le drain est relié est à un réseau 10 d'adaptation d'impédance de sortie de l'oscillateur.

La cavité comporte une ouverture 16 dans laquelle est engagé le corps d'un microphone 17. La partie supérieure 171 du microphone 17 est orientée vers l'espace libre pouvant recevoir des ondes de pression acoustique, notamment des ordres sous forme vocale de la part d'un utilisateur alors que la partie inférieure 172 du microphone est quant à elle en regard de la partie supérieure du résonateur. La base de la partie supérieure 171 recevant la voix de l'utilisateur se rétrécit jusqu'au niveau d'une membrane 18 en contact avec une bobine métallique19. Celle-ci est susceptible de se déplacer dans la direction perpendiculaire au résonateur sous l'effet de la vibration de la membrane recevant des ondes acoustiques.

Ainsi, la vibration mécanique de la membrane avec sa bobine permet de mesurer la pression acoustique exercée par l'utilisateur traduisant sa voix. La modulation mécanique dé cette membrane avec sa bobine modifie les propriétés de la cavité, ce qui a pour conséquence une modulation de la fréquence instantanée du signal SHF créé par le résonateur (par exemple à 5,8 GHz) au rythme du signal de la voix à transmettre. Un avantage de l'invention provient de la simplicité du microphone utilisé dans le présent mode de réalisation, qui est dépourvu de son aimant.

Pour plus d'informations, on se référera au chapitre II relatif à l'utilisation de résonateurs diélectriques, page 30 et suite de l'ouvrage, "Composants, dispositifs et circuits actifs en micro-ondes" de P.F Combes, J. Graffeuil et J.F. Sautereau, Edition Dunod Université, ainsi que l'article "Current techniques for tuning dielectric resonators" de B.S. Virdee, paru dans la revue "Microwave journal", octobre 1998.

Comme représenté sur la figure 4, le résonateur étant centré sur une fréquence centrale F0, une modification de la distance d équivalent à δd1 entraîne une déviation de fréquence δF0 de l'ordre de 5% sans importance sur les performances de l'oscillateur. Cette faible variation δF0 peut être considérée comme linéaire ou quasi-linéaire en fonction du déplacement δd1 de la bobine dans la cavité, ce qui assure une modulation directe du signal généré par le résonateur par le signal audio sans distorsion de celui-ci.

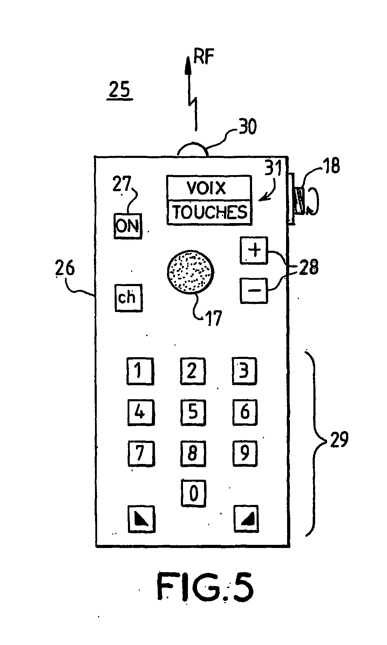

Il est représenté sur la figure 3 en pointillés, selon une caractéristique supplémentaire de l'invention, une vis 180 de réglage mécanique, réglable de l'extérieur de la cavité 2 et dont la partie 181 engagée dans la cavité est en regard du résonateur latéralement et est positionnée de manière à pouvoir ajuster le cas échéant la fréquence centrale de l'oscillateur. II est également illustré sur la figure 3 en pointillés, selon une caractéristique supplémentaire, une connexion 20 reliant via une résistance 21 la ligne microruban 5 à un microprocesseur 22 générant un signal numérique significatif de la sélection par l'utilisateur d'une commande 24 d'un tableau de commandes 23. Selon ce dernier mode, le signal généré par le résonateur est soit modulé par le déplacement de la bobine 19 généré par les ondes acoustiques reçues au niveau de la membrane, soit par les données transmises par le microprocesseur sous forme d'impulsions. Cette possibilité de choix du signal modulant est permise par l'utilisation d'un interrupteur, non représenté sur la figure 3, qui autorise la transmission de la voix ou des données. Une application de ce mode est représentée sur la figure 5 illustrant un dispositif de télécommande pour la commande de tout appareil commandable, notamment un appareil domestique (téléviseur, magnétoscope, caméscope, lecteur/enregistreur de disques ou de cassettes numériques ...).

Le dispositif de télécommande 25 illustré sur la figure 5 comporte, de façon classique, un clavier 26 présentant des touches 24 dont celle de mise en veille 27, d'augmentation et de diminution du son 28, un pavé numérique 29 permettant notamment le choix d'un canal, et un émetteur 30 de signaux à haute fréquence (HF). Le dispositif de télécommande comporte en outre un microphone 17 et un interrupteur 31 de sélection du mode de communication que l'utilisateur veut établir : un mode vocal correspondant à une touche "voix" dans lequel le signal généré par le résonateur est modulé par la voix de l'utilisateur, et un mode de sélection par touches correspondant à la touche "touches" dans lequel le signal généré par le résonateur est modulé par le signal généré par le microprocesseur qui est fonction des touches actionnées.

Bien entendu, l'invention n'est pas limitée aux modes de réalisation décrits dans la présente demande. Les commandes vocales sont de diverses sortes. De façon non limitative, on citera, tout d'abord, la syntonisation sur un canal. Dans ce cas, l'utilisateur prononce le nom attribué au canal ou le numéro correspondant.

La commande vocale peut aussi être utilisée pour simplifier des opérations qui nécessitent des actions successives quand elles sont commandées par des touches. Par exemple, pour commander la luminosité à l'aide du clavier de la télécommande, il est nécessaire d'accéder d'abord à un menu s'affichant sur l'écran du récepteur et, ensuite, de sélectionner, dans ce menu, par une ou plusieurs opérations, la commande de luminosité. Avec la commande vocale, il n'est pas nécessaire d'effectuer les opérations successives. Il suffit de prononcer, par exemple, le mot "luminosité". Dans ce cas, l'augmentation ou la diminution de la luminosité peut s'effectuer soit par commande vocale, soit à l'aide des touches classiques d'augmentation et de diminution ("plus" et "moins") sur le boîtier de télécommande.

Bien entendu, l'application n'est pas limitée aux télécommandes vocales et peut être envisagée pour des commandes vocales d'un autre type (filaires par exemple), ou encore un microphone.

## Revendications

1. Oscillateur à résonateur diélectrique, comprenant :
- un résonateur diélectrique (4) confiné dans une cavité (2) résonante pour la génération d'un signal oscillant à une fréquence centrale prédéterminée, les dimensions du résonateur et les conditions aux limites dans la cavité étant aptes à déterminer la fréquence de résonance du résonateur;
- des moyens sensibles aux ondes de pression acoustique aptes à modifier la distribution des champs électromagnétiques dans la cavité en fonction desdites ondes de pression acoustique;
- les moyens sensibles aux ondes acoustiques comprenant une membrane (18) mobile sous l'effet des ondes acoustiques, **caractérisé en ce que** ladite membrane engage une bobine (19) métallique dans la cavité.

2. Oscillateur, selon la revendication 1, **caractérisé en ce que** lesdits moyens sensibles aux ondes de pression acoustique comprennent des moyens de transduction acoustique (17, 18, 19) pour convertir des ondes de pression acoustique en déplacement (d) d'au moins une partie de moyens amovibles (18, 19) en regard du résonateur, le déplacement d'au moins une partie de ces moyens amovibles sous l'effet d'ondes de pression acoustique étant capable de modifier la distribution des champs électromagnétiques dans la cavité.

3. Oscillateur selon la revendication 2, **caractérisé en ce que** le déplacement desdits moyens amovibles s'effectue sous forme de vibrations.

4. Oscillateur selon l'une des revendications 1 à 3, **caractérisé en ce qu'**il comprend des moyens de réglage (180) pour régler la fréquence centrale du résonateur.

5. Oscillateur selon la revendication 4, **caractérisé en ce que** lesdits moyens de réglage comprennent une vis de réglage (180) pouvant s'engager dans la cavité pour modifier la distribution des champs électromagnétiques dans celle-ci.

6. Oscillateur selon l'une des revendications 1 à 5, **caractérisé en ce qu'**il comprend des moyens de commutation (31) pour commuter la modulation du signal généré par le résonateur par les ondes acoustiques vers une modulation par des données transmises sur une voie (20).

7. Oscillateur selon l'une des revendications 1 à 6, **caractérisé en ce qu'**un dipôle actif (7) est couplé audit résonateur par des moyens de couplage (5) pour l'entretien des oscillations.

8. Dispositif de commande vocale, **caractérisé en ce qu'**il comprend un oscillateur selon l'une des revendications 1 à 7.

## Patentansprüche

1. Oscillator mit einem dielektrischen Resonator mit:
- einem dielektrischen Resonator (4) in einer Resonanzkammer (2) zur Erzeugung eines bei einer vorbestimmten Mittenfrequenz schwingenden Signals, wobei die Abmessungen des Resonators und die Grenzbedingungen in der Kammer für die Bestimmung der Resonanzfrequenz des Resonators geeignet sind,
- auf akustische Druckwellen ansprechenden Mitteln zur Änderung der Verteilung der elektromagnetischen Felder in der Kammer in Abhängigkeit von den akustischen Druckwellen,
- wobei die auf die akustischen Wellen ansprechende Mittel eine Membran (18) enthalten, die durch die Wirkung der akustischen Wellen bewegbar ist,
**dadurch gekennzeichnet, dass**
die Membran eine Metallspule (19) in der Kammer umfaßt.

2. Oscillator nach Anspruch 1, **dadurch gekennzeichnet, dass** die auf die akustischen Druckwellen ansprechenden Mittel akustische Umsetzmittel (17, 18, 19) zur Umsetzung der akustischen Druckwellen in eine Verschiebung (d) wenigstens eines Teils der bewegbaren Mittel (18, 19) gegenüber dem Resonator enthalten, und dass die Verschiebung wenigstens eines Teils der bewegbaren Mittel durch die Wirkung der akustischen Druckwellen in der Lage ist, die Verteilung der elektromagnetischen Felder in der Kammer zu ändern.

3. Oscillator nach Anspruch 2, **dadurch gekennzeichnet, dass** die Verschiebung der bewegbaren Mittel in der Form von Vibrationen erfolgt.

4. Oscillator nach einem der Ansprüche 1 bis 3, **dadurch gekennzeichnet, dass** er Einstellmittel (180) zur Einstellung der Mittenfrequenz des Resonators enthält.

5. Oscillator nach Anspruch 4, **dadurch gekennzeichnet, dass** die Einstellmittel eine Einstellschraube (180) enthalten, die in die Kammer eingreifen kann, um in dieser die Verteilung der elektromagnetischen Felder zu ändern.

6. Oscillator nach einem der Ansprüche 1 bis 5, **dadurch gekennzeichnet, dass** er Schaltmittel (31) enthält zur Umschaltung der Modulation der akustischen Wellen des durch den Resonator erzeugten Signals in eine Modulation durch über einen Kanal (20) übertragene Daten.

7. Oscillator nach einem der Ansprüche 1 bis 6, **dadurch gekennzeichnet, dass** ein aktiver Zweipol (7) durch Kopplungsmittel (5) mit dem Resonator verbunden ist, um die Schwingungen aufrechtzuerhalten.

8. Vorrichtung zur Sprachsteuerung, **dadurch gekennzeichnet, dass** sie einen Oscillator nach einem der Ansprüche 1 bis 7 enthält.

## Claims

1. Dielectric resonator oscillator, comprising:
- a dielectric resonator (4) contained in a resonant cavity (2) in order to generate a signal oscillating at a predetermined central frequency, the dimensions of the resonator and the limiting conditions in the cavity being capable of determining the resonant frequency of the resonator;
- means sensitive to acoustic pressure waves capable of modifying the distribution of the electromagnetic fields in the cavity as a function of said acoustic pressure waves,
- the means sensitive to acoustic waves comprising a membrane (18) which is movable under the effect of acoustic waves, **characterized in that** said membrane engages a metal coil (19) in the cavity.

2. Oscillator according to Claim 1, **characterized in that** said means sensitive to acoustic pressure waves comprise acoustic transducer means (17, 18, 19) to convert the acoustic pressure waves into a displacement (d) of at least part of detachable means (18, 19) facing the resonator, the displacement of at least part of these detachable means under the effect of acoustic pressure waves being capable of modifying the distribution of the electromagnetic fields in the cavity.

3. Oscillator according to Claim 2, **characterized in that** the displacement of said detachable means is carried out in the form of vibrations.

4. Oscillator according to one of Claims 1 to 3, **characterized in that** it comprises adjustment means (180) to adjust the central frequency of the resonator.

5. Oscillator according to Claim 4, **characterized in that** said adjustment means comprise an adjustment screw (180) which can be engaged in the cavity in order to modify the distribution of the electromagnetic fields therein.

6. Oscillator according to one of Claims 1 to 5, **characterized in that** it comprises switching means (31) to switch the modulation by acoustic waves of the signal generated by the resonator to modulation by data transmitted over a channel (20).

7. Oscillator according to one of Claims 1 to 6, **characterized in that** an active dipole (7) is coupled to said resonator by coupling means (5) in order to maintain the oscillations.

8. Voice control device, **characterized in that** it comprises an oscillator according to one of Claims 1 to 7.
